# EUROPÄISCHE PATENTANMELDUNG

(11) **EP 4 019 470 A1**
(43) Veröffentlichungstag der Anmeldung: **29.06.2022**
(21) Anmeldenummer: 20020649.8
(22) Anmeldetag: 23.12.2020
(51) Int. Cl.: C01G 39/04

(54) **HERSTELLUNG VON MOO2CL2**

(71) Anmelder: UMICORE AG & Co. KG, 63457 Hanau-Wolfgang (DE)
(72) Erfinder: EBERT, Timo, 63796 Kahl (DE); FREY, Annika, 63457 Hanau (DE); RAU, Nicholas, 35039 Marburg (DE); SCHORN, Wolf, 76337 Waldbronn (DE); KARCH, Ralf, 63801 Kleinostheim (DE); WOERNER, Eileen, 61130 Nidderau (DE); DOPPIU, Angelino, 63500 Seligenstadt (DE)
(74) Vertreter: Clauswitz, Kai-Uwe Wolfram

(57) **Zusammenfassung**

Gegenstand der Erfindung ist ein Verfahren zur Herstellung von MoO₂Cl₂ unter inerten Bedingungen, umfassend die Schritte:
(i) Vorlegen von MoO₂ in einem Reaktionsgefäß,
(ii) Umsetzen des MoO₂ in dem Reaktionsgefäß bei einer ersten Temperatur T₁ mit zugeführtem Cl₂ zu gasförmigem MoO₂Cl₂,
(iii) Überführen des gasförmigen MoO₂Cl₂ in ein Auffanggefäß,
(iv) Resublimieren des gasförmigen MoO₂Cl₂ in dem Auffanggefäß zu festem MoO₂Cl₂ bei einer zweiten Temperatur T₂, die niedriger als T₁ liegt, und
(v) Rückgewinnen von festem MoO₂Cl₂ mit einer Reinheit bestimmt durch ICP-OES/MS von 99,9996 Gew.-% oder mehr.

Weitere Gegenstände der Erfindung sind hochreines MoO₂Cl₂, dessen Verwendung und Elektronikkomponenten.

## Beschreibung

Die Erfindung betrifft Verfahren zur Herstellung von Molybdändioxiddichlorid (MoO₂Cl₂) sowie durch solche Verfahren erhältliches (MoO₂Cl₂), dessen Verwendung und Elektronikkomponenten.

### Stand der Technik

In Elektronikkomponenten kommen häufig Molybdän-haltige Schichten zum Einsatz, z.B. in sogenannten Flash-Speichern. Solche Molybdän-haltigen Schichten werden häufig mittels Gasphasenabscheidung erzeugt. In einer solchen Gasphasenabscheidung wird als Präkursor für das Molybdän zunehmend (MoO₂Cl₂) eingesetzt. Um vorteilhafte elektronische Eigenschaften der Molybdän-haltigen Schichten zu erzielen, ist dabei der Einsatz von besonders reinem (MoO₂Cl₂) wünschenswert. Insbesondere soll das (MoO₂Cl₂) möglichst frei von metallischen Verunreinigungen sein, welche die elektronischen Eigenschaften beeinträchtigen können. Ein besonderes Augenmerk liegt hierbei auf Wolfram als Verunreinigung, da Wolfram die elektronischen Eigenschaften einer Molybdän-haltigen Schicht besonders beeinträchtigen kann. Dementsprechend ist insbesondere ein möglichst Wolfram-freies (MoO₂Cl₂) wünschenswert.

Die Herstellung von (MoO₂Cl₂) ist an sich bekannt. Zum Beispiel beschreiben Schrock et al. (J. Am. Chem. Soc., 1990, 112, 3875-3886) die Herstellung von (MoO₂Cl₂) aus Molybdän(IV)oxid (MoO₂) und Chlorgas (Cl₂). Die Umsetzung im Reaktionsgefäß erfolgt bei 160°C. Eine weitergehende aktive Temperatureinstellung der Versuchsapparatur erfolgt nicht. Der eingestellte Cl₂-Gasstrom wird nicht angegeben, und die Reinheit des hergestellten (MoO₂Cl₂) wird nicht bestimmt.

Aus CN 102632245 A ist ein Verfahren zur Herstellung von Molydänpulver bekannt, bei dem durch Reaktion von MoO₂ mit Cl₂ intermediär (MoO₂Cl₂) gebildet wird. Es werden keine Angaben zur Atmosphäre gemacht, unter der die Reaktion durchgeführt wird. Zu der Reinheit des intermediär hergestellten (MoO₂Cl₂) werden ebenfalls keine Angaben gemacht. Das intermediär hergestellte (MoO₂Cl₂) wird nachfolgend mit Ammoniakwasser zu Ammoniumparamolybdat umgesetzt. Dieses wird in Molybdän(VI)oxid (MoO₃) überführt, aus welchem letztlich Molydänpulver gewonnen wird.

Aus EP 3 656 741 A1 ist ein Verfahren zur Herstellung von Molybdänoxidchloriden aus einem Molydänoxid und Cl₂ unter verringertem Druck bekannt. Die hergestellten Molybdänoxidchloride umfassen neben (MoO₂Cl₂) auch Molybdänoxidtrichlorid (MoOCl₃) und Molybdänoxidtetrachlorid (MoOCl₄). In den Ausführungsbeispielen wird (MoO₂Cl₂) durch Umsetzen von MoO₃ mit Cl₂ hergestellt. Die Reinheit des hergestellten (MoO₂Cl₂) ist auf 99,9995 Gew.-% begrenzt.

Die im Stand der Technik eingesetzten Verfahren zur Herstellung von (MoO₂Cl₂) sind teilweise noch verbesserungsbedürftig.

### Aufgabe der Erfindung

Der Erfindung liegt als eine Aufgabe zugrunde, ein Verfahren zur Herstellung von (MoO₂Cl₂) bereitzustellen, welches die Nachteile des Stands der Technik zumindest teilweise und möglichst ganz überwindet.

Es ist dabei eine besondere Aufgabe der Erfindung, ein Verfahren zur Herstellung von (MoO₂Cl₂) bereitzustellen, welches besonders reines (MoO₂Cl₂) liefert, insbesondere (MoO₂Cl₂) mit geringem Wolframgehalt.

Der Erfindung liegt als eine weitere Aufgabe zugrunde, ein Verfahren zur Herstellung einer Molybdän-haltigen Schicht bereitzustellen, welches die Nachteile des Stands der Technik zumindest teilweise und möglichst ganz überwindet.

Es ist ferner eine Aufgabe der Erfindung, (MoO₂Cl₂) bereitzustellen, welches die Nachteile des Stands der Technik zumindest teilweise und möglichst ganz überwindet, und insbesondere (MoO₂Cl₂) mit verbesserter Reinheit bereitzustellen.

Es ist zudem eine Aufgabe der Erfindung, eine Verwendung von (MoO₂Cl₂) als Präkursor zur Herstellung einer Molybdän-haltigen Schicht bereitzustellen, welche die Nachteile des Stands der Technik zumindest teilweise und möglichst ganz überwindet.

Es ist außerdem eine Aufgabe der Erfindung, eine Elektronikkomponente mit einer Molybdän-haltigen Schicht bereitzustellen, welche die Nachteile des Stands der Technik zumindest teilweise und möglichst ganz überwindet

### Offenbarung der Erfindung

Überraschenderweise werden die der Erfindung zugrunde liegenden Aufgaben durch Verfahren, Produkte und Verwendungen gemäß den Patentansprüchen gelöst.

Gegenstand der Erfindung ist ein Verfahren zur Herstellung von (MoO₂Cl₂) unter inerten Bedingungen, umfassend die Schritte:
(i) Vorlegen von MoO₂ in einem Reaktionsgefäß,
(ii) Umsetzen des MoO₂ in dem Reaktionsgefäß bei einer ersten Temperatur T₁ mit zugeführtem Cl₂ zu gasförmigem (MoO₂Cl₂),
(iii) Überführen des gasförmigen (MoO₂Cl₂) in ein Auffanggefäß,
(iv) Resublimieren des gasförmigen (MoO₂Cl₂) in dem Auffanggefäß zu festem (MoO₂Cl₂) bei einer zweiten Temperatur T₂, die niedriger als T₁ liegt, und
(v) Rückgewinnen von festem (MoO₂Cl₂) mit einer Reinheit bestimmt durch ICP-OES/MS von 99,9996 Gew.-% oder mehr.

Das erfindungsgemäße Verfahren wird unter inerten Bedingungen durchgeführt und wird bevorzugt kontinuierlich unter inerten Bedingungen durchgeführt. Außer dem im Schritt (ii) zugeführten Cl₂ wird das Verfahren damit unter Ausschluss anderer reaktiver Gase bzw. Substanzen durchgeführt. Dementsprechend wird das Verfahren bevorzugt unter Sauerstoffausschluss und/oder Luftausschluss und/oder Wasserausschluss durchgeführt. Insbesondere bevorzugt wird das Verfahren in einer Atmosphäre aus reinem Cl₂ oder in einer Atmosphäre aus einem Cl₂-N₂-Gemisch durchgeführt.

Das erfindungsgemäße Verfahren wird ferner mit MoO₂ als einzigem Molydän-haltigen und/oder einzigem oxidischen Ausgangsstoff durchgeführt. Insbesondere wird in dem erfindungsgemäßen Verfahren kein anderes Molydänoxid wie MoO oder MoO₃ eingesetzt. Allerdings kann das vorgelegte MoO₂ Verunreinigungen enthalten, insbesondere metallische Verunreinigungen wie Wolfram (W). Es ist erfindungsgemäß auch bevorzugt, dass in dem erfindungsgemäßen Verfahren neben (MoO₂Cl₂) kein anderes Molybdänoxidchlorid hergestellt wird, insbesondere kein MoOCl₃ und/oder kein MoOCl₄.

Die Bestimmung der Reinheit des im Schritt (v) rückgewonnenen (MoO₂Cl₂) erfolgt mittels gekoppelter ICP-OES/MS. Dabei wird ein induktiv gekoppeltes Plasma (ICP, *"inductively coupled plasma"*) als Anregungsquelle eingesetzt. Zunächst wird das (MoO₂Cl₂) in einen Inertgasstrom (z.B. Argonstrom) eingebracht, auf den dann durch die induktive Kopplung elektrodenlos Hochfrequenzenergie übertragen wird. Die hierzu eingesetzten Frequenzen liegen typischerweise im Bereich von 25 und 100 MHz. Die eingesetzten Generatoren haben typischerweise Leistungen zwischen 1 und 10 kW. Der Inertgasstrom erhitzt sich dabei auf Temperaturen von typischerweise bis zu 10000 K. Das (MoO₂Cl₂) wird hierdurch atomisiert bzw. ionisiert. Die entstehenden freien Atome und/oder Ionen werden sowohl optisch mittels Atomemissionsspektrometrie (OES; *"Optical Emission Spectrometry"*) als auch mittels Massenspektrometrie (MS) analysiert.

Mittels Optischer Emissionsspektrometrie mit induktiv gekoppeltem Plasma (ICP-OES; auch ICP-AES, ICP-Atomspektrometrie) können regelmäßig Elemente in Lösungen nachgewiesen und quantifiziert werden. Die zu messende Lösung wird wie vorstehend beschrieben zerstäubt und das gebildete Aerosol in ein Hochfrequenzplasma eingebracht, in dem die Lösungsbestandteile atomisiert und teilweise ionisiert werden. Die charakteristischen Emissionslinien der Atome und Ionen werden mit einem Monochromator oder Polychromator zerlegt und die Linienintensitäten mit einem geeigneten Detektor erfasst. Die Messung kann axial und/oder radial erfolgen. Erfindungsgemäß erfolgt die Messung bevorzugt axial, da die axiale Messung empfindlicher ist. Zur quantitativen Bestimmung kann eine Kalibration mit geeigneten Standardlösungen erfolgen, da ein linearer Zusammenhang zwischen den Signalintensitäten der Emission und den Konzentrationen eines Elements besteht. Erfindungsgemäß ist es bevorzugt, dass das Messprinzip der ICP-OES der DIN EN ISO 11885 (1997) / DEV E22 und/oder der Richtlinie zur chemischen Analyse, Bestimmung von Elementgehalten in Umweltproben durch ICP-OES, Fraunhofer-Institut für Molekularbiologie und Angewandte Oekologie, Auf dem Aberg 1, D-57392 Schmallenberg, folgt.

Mittels Massenspektrometrie mit induktiv gekoppeltem Plasma (ICP-MS) können regelmäßig Elemente in Lösungen nachgewiesen und quantifiziert werden. Die zu messende Lösung wird wie vorstehend beschrieben zerstäubt und in ein Hochfrequenzplasma eingebracht, in dem die Lösungsbestandteile atomisiert und ionisiert werden. Die Ionen werden durch ein Lochblendensystem aus dem Hochfrequenzplasma extrahiert und nach ihrem Masse/Ladungs-Verhältnis aufgetrennt. Nach der Auftrennung werden sie in einem Detektor registriert und die entstehenden Signale über die Gerätesoftware ausgewertet. Eine quantitative Bestimmung wird nach Kalibration mit Standardlösungen möglich, da ein linearer Zusammenhang zwischen den Signalintensitäten der Ionen und den Konzentrationen eines Elements besteht. Erfindungsgemäß ist es bevorzugt, dass das Messprinzip der ICP-MS der DIN EN ISO 17294-2:2017-01 (Wasserbeschaffenheit - Anwendung der induktiv gekoppelten Plasma-Massenspektrometrie (ICP-MS) - Teil 2: Bestimmung von ausgewählten Elementen einschließlich Uran-Isotope (ISO 17294-2:2016); Deutsche Fassung EN ISO 17294-2:2016) und/oder der Richtlinie zur chemischen Analyse, Bestimmung von Elementgehalten in Umweltproben durch ICP-MS, Fraunhofer-Institut für Molekularbiologie und Angewandte Oekologie, Auf dem Aberg 1, D-57392 Schmallenberg, folgt.

Die Kopplung der beiden Analysemethoden OES und MS ermöglicht, eine große Bandbreite an Elementen zu analysieren. Beispielsweise sind leichtere Elemente mit OES schlechter bestimmbar. Der gleichzeitige Einsatz von MS ermöglicht jedoch deren Bestimmung. Es bedarf daher einer Koppelung der Analysemethoden. Die mit den beiden Analysemethoden bestimmten Elementanteile sind für gleiche Elemente konsistent, d.h. sie liefern im Rahmen der üblichen Messgenauigkeiten übereinstimmende Ergebnisse. Erfindungsgemäß ist es bevorzugt, dass für die gekoppelte ICP-OES/MS Geräte der Firma Thermo Fischer mit den Typenbezeichnungen iCap, iCap Duo bzw. iCap RQ eingesetzt werden.

Mit der Bestimmung über ICP-OES/MS können Verunreinigungen im dem rückgewonnenen MoO₂Cl₂, insbesondere metallische Verunreinigungen wie Wolfram, im ppb-Bereich (*"parts per billion";* Milliardstel) bestimmt werden. Die hierin angegebenen ppb-Werte bzw. ppb-Grenzen entsprechen der jeweiligen Nachweisgrenze der Verunreinigungen.

Mit dem erfindungsgemäßen Verfahren kann besonders reines MoO₂Cl₂ hergestellt werden, insbesondere kann MoO₂Cl₂ mit geringem Wolframgehalt hergestellt werden. Erfindungsgemäß ist es dabei bevorzugt, dass die Reinheit des im Schritt (v) rückgewonnenen MoO₂Cl₂ 99,99969 Gew.-% oder mehr beträgt. Mit derart reinem MoO₂Cl₂ können Molybdän-haltige Schichten mit weiter verbesserten elektronischen Eigenschaften hergestellt werden.

Erfindungsgemäß ist es ferner bevorzugt, dass das im Schritt (v) rückgewonnene feste MoO₂Cl₂ einen Wolframgehalt, wiederum bestimmt durch ICP-OES/MS, von ≤ 200 ppb und insbesondere bevorzugt von ≤ 50 ppb aufweist. Wolfram als Verunreinigung kann die elektronischen Eigenschaften von Molybdän-haltigen Schichten besonders beinträchtigen. Durch die erfindungsgemäßen niedrigen Wolframgehalte können derartige Beeinträchtigungen vermieden und die elektronischen Eigenschaften weiter verbessert werden.

Neben dem Wolfram können in dem MoO₂Cl₂ ggf. auch noch sehr geringe Mengen anderer Verunreinigungen enthalten sein, insbesondere (halb)metallische Verunreinigungen wie Ag, Al, Au, B, Ba, Be, Bi, Ca, Cd, Ce, Co, Cr, Cu, Fe, Ga, Ge, Hf, In, Ir, K, La, Li, Mg, Mn, Na, Nb, Ni, Pb, Pd, Pt, Rb, Rh, Ru, Sb, Se, Sn, Sr, Te, Th, Ti, Tl, U, V, W, Zn und Zr. Erfindungsgemäß ist es dabei bevorzugt, dass das im Schritt (v) rückgewonnene MoO₂Cl₂ bezüglich jeder einzelnen dieser unabhängig voneinander betrachteten Verunreinigungen einen Gehalt von ≤ 300 ppb, mehr bevorzugt von ≤ 200 ppb, noch mehr bevorzugt von ≤ 100 ppb, insbesondere bevorzugt von ≤ 50 ppb und am meisten bevorzugt von ≤ 20 ppb aufweist. Durch die erfindungsgemäßen niedrigen Gehalte derartiger Verunreinigungen in dem MoO₂Cl₂ können die elektronischen Eigenschaften daraus erhaltener Molybdän-haltiger Schichten weiter verbessert sein.

Erfindungsgemäß ist es ferner bevorzugt, dass im Schritt (ii) die erste Temperatur T₁ ≥ 170°C, mehr bevorzugt ≥ 170 bis ≤ 600°C, noch mehr bevorzugt ≥ 200 bis ≤ 500°C, insbesondere bevorzugt ≥ 350 bis ≤ 450°C und am meisten bevorzugt 400°C beträgt. Mit derartigen Temperaturen kann ein Ausgleich zwischen erhöhten Reaktionsgeschwindigkeiten durch erhöhte Temperaturen einerseits und unnötigem Energieverbrauch durch übermäßig hohe Temperaturen andererseits erzielt werden. Dabei ist es in einer bevorzugten Ausführungsform auch möglich, dass das Reaktionsgefäß in verschiedene physikalische und/oder theoretische Reaktionszonen unterteilt ist, in denen die Temperatur T₁ innerhalb der vorstehend genannten Temperaturbereiche unterschiedlich eingestellt wird.

Im Schritt (ii) wird bevorzugt ein Reaktionsgefäß eingesetzt, dessen Temperatur steuerbar oder regelbar ist. Z.B. wird ein Drehrohrofen, ein statischer Ofen oder ein Fallrohrofen eingesetzt. Erfindungsgemäß ist ein Drehrohrofen bevorzugt, der verschiedene, unterschiedlich beheizbare (und abkühlbare) Reaktionszonen aufweist. Mit einem solchen Ofen können ein oder mehrere Temperaturgradienten im Ofen eingestellt werden, die zu einer weitergehenden Verbesserung der Reinheit des im Schritt (ii) hergestellten (MoO₂Cl₂) beitragen können.

Erfindungsgemäß ist es ferner bevorzugt, dass im Schritt (iv) die zweite Temperatur T₂ ≤ 160°C, mehr bevorzugt ≥ 10 bis ≤ 120°C, noch mehr bevorzugt ≥ 20 bis ≤ 90°C, insbesondere bevorzugt ≥ 25 bis ≤ 70°C und am meisten bevorzugt 70°C beträgt. Mit derartigen Temperaturen kann ein Ausgleich zwischen hoher Ausbeute an MoO₂Cl₂ und einem geringen Einbau von Verunreinigungen in das MoO₂Cl₂ während des Resublimierens erzielt werden.

Erfindungsgemäß ist es insbesondere bevorzugt, die zweite Temperatur T₂ zwischen dem Beginn und dem Ende des erfindungsgemäßen Verfahrens zu variieren. Dabei ist es besonders bevorzugt, die Temperatur T₂ in dem Auffanggefäß von einer höheren Temperatur auf eine niedrigere Temperatur abzusenken, bevorzugt von 90°C auf bis zu 20°C, mehr bevorzugt von 70°C auf 25°C. Mit einer derartigen Temperaturführung kann beim Resublimieren im Schritt (iv) eine besonders hohe Reinheit des (MoO₂Cl₂) eingestellt werden.

Im Schritt (iv) wird bevorzugt ein Auffanggefäß eingesetzt, dessen Temperatur steuerbar oder regelbar ist. Z.B. wird ein Auffangkolben eingesetzt. Alternativ kann auch ein Kühlfinger eingesetzt werden, an dem gasförmiges MoO₂Cl₂ resublimiert. Das resublimierte MoO₂Cl₂ kann aus dem Auffangkolben auf übliche Weise entnommen oder von dem Kühlfinger thermisch abgelöst werden.

Erfindungsgemäß ist es besonders bevorzugt, dass die erste Temperatur T₁ und die zweite Temperatur T₂ gleichzeitig wie vorstehend aufgeführt eingestellt werden. Dementsprechend sind folgende Temperaturpaare bzw. Temperaturführungen besonders bevorzugt:
T₁ ≥ 170°C und T₂ ≤ 160°C;
T₁ ≥ 170 bis ≤ 600°C und T₂ ≥ 10 bis ≤ 120°C;
T₁ ≥ 200 bis ≤ 500°C und T₂ ≥ 20 bis ≤ 90°C;
T₁ ≥ 350 bis ≤ 450°C und T₂ ≥ 25 bis ≤ 70°C;
T₁ = 400°C und T₂ = 70°C;
T₁ ≥ 350 bis ≤ 450°C, und T₂ beträgt zu Anfang des Verfahrens 90°C und wird bis zum Ende des Verfahrens auf bis zu 20°C abgesenkt;
T₁ = 400°C und T₂ beträgt zu Anfang des Verfahrens 70°C und wird bis zum Ende des Verfahrens auf 25°C abgesenkt.
Mit diesen Temperaturpaaren bzw. Temperaturführungen kann ein Ausgleich zwischen erhöhter Reaktionsgeschwindigkeit, verringertem Energieverbrauch, hoher Ausbeute und geringem Einbau von Verunreinigungen erzielt werden.

Erfindungsgemäß ist es daneben bevorzugt, dass der Schritt (iii) bei einer Temperatur von ≥160°C durchgeführt wird. Mit einer solchen Temperatur kann ein verfrühtes Resublimieren von MoO₂Cl₂ verhindert und damit die Ausbeute im Auffanggefäß erhöht werden.

Erfindungsgemäß ist es außerdem bevorzugt, dass im Schritt (ii) der Gasstrom des Cl₂ 0,01 bis 1 L/min und mehr bevorzugt 0,05 bis 0,8 L/min beträgt. Mit einem derartigen Gasstrom kann ein Ausgleich zwischen erhöhter Reaktionsgeschwindigkeit und erhöhter Ausbeute einerseits und unnötigem Einsatz von Chlor mit einem sich daran möglicherweise anschließenden Problem der Entsorgung unverbrauchten Chlors andererseits erzielt werden.

Erfindungsgemäß ist es außerdem bevorzugt, dass im Schritt (ii) zusätzlich ein Inertgas, bevorzugt Stickstoff (N₂), zugeführt wird. Mit derartig zusätzlich zugeführtem Inertgas, insbesondere N₂, kann das erfindungsgemäße Verfahren noch sicherer unter inerten Bedingungen durchgeführt werden. Dabei ist es erfindungsgemäß besonders bevorzugt, dass der Gasstrom des Inertgases, insbesondere des N₂, 0,05 bis 0,4 L/min, mehr bevorzugt 0,1 bis 0,3 L/min und besonders bevorzugt 0,2 L/min beträgt, wobei die Wahl des Gasstroms von Ofengröße und -konfiguration abhängt und entsprechend anzupassen ist.Mit einem derartigen Gasstrom des Inertgases, insbesondere des N₂, können die inerten Bedingungen noch besser aufrechterhalten werden, ohne unnötig große Mengen an Inertgas einzusetzen. Zudem kann ein solcher Gasstrom einen verbesserten Transport des gasförmigen (MoO₂Cl₂) vom Reaktionsgefäß zum Auffanggefäß ermöglichen. Neben N₂ können auch andere Inertgase zum Einsatz kommen, zum Beispiel Argon (Ar). Der Einsatz von Ar kann zu einer weiter verbesserten Reinheit des (MoO₂Cl₂) führen. Erfindungsgemäß ist der Einsatz von N₂ aufgrund seiner geringeren Kosten am meisten bevorzugt.

Erfindungsgemäß ist es zudem bevorzugt, dass im Schritt (ii) der Gasstrom des Cl₂ 0,01 bis 1 L/min und mehr bevorzugt 0,05 bis 0,8 L/min beträgt und gleichzeitig N₂ mit einem Gasstrom von 0,05 bis 0,4 L/min und mehr bevorzugt von 0,1 bis 0,3 L/min zugeführt wird (0,01 bis 1 L/min Cl₂ und 0,05 bis 0,4 L/min N₂; 0,05 bis 0,8 L/min Cl₂ und 0,05 bis 0,4 L/min N₂; 0,01 bis 1 L/min Cl₂ und 0,1 bis 0,3 L/min N₂; bzw. 0,05 bis 0,8 L/min Cl₂ und 0,1 bis 0,3 L/min N₂). Erfindungsgemäß ist es am meisten bevorzugt, dass im Schritt (ii) Cl₂ mit einem Gasstrom von 0,8 L/min und N₂ mit einem Gasstrom von 0,2 L/min zugeführt wird. Mit derartigen Gasströmen kann ein noch weiter verbesserter Ausgleich zwischen Reaktionsgeschwindigkeit, erhöhter Ausbeute, unnötigem Einsatz von Cl₂ und damit verbunden Entsorgungsproblemen sowie Aufrechterhaltung der inerten Bedingungen ohne übermäßigen Einsatz von Inertgas und verbessertem Transport des gasförmigen MoO₂Cl₂ erzielt werden.

Erfindungsgemäß ist es auch bevorzugt, dass das Reaktionsgefäß, das Auffanggefäß und ggf. ein optional zwischen dem Reaktionsgefäß und dem Auffanggefäß angeordneter Übergangsbereich vor dem Schritt (i) durch Spülen mit einem Inertgas, vorzugsweise Stickstoff, inertisiert werden. Unter *"inertisieren"* wird dabei wie allgemein üblich das Einstellen inerter Bedingungen in einer Apparatur verstanden. Durch das Spülen mit einem Inertgas können die inerten Bedingungen des erfindungsgemäßen Verfahrens besonders schnell und effizient eingestellt werden. Erfindungsgemäß ist es auch bevorzugt, dass das erfindungsgemäße Verfahren keinen Schritt einer Druckreduzierung umfasst, insbesondere keinen Schritt, in dem der Druck im Reaktionsgefäß und/oder im Auffanggefäß reduziert wird.

Erfindungsgemäß ist es auch bevorzugt, dass das im Schritt (v) erhaltene (MoO₂Cl₂) in einem nachfolgenden Schritt (vi) durch Sublimation und erneute Resublimation weiter gereinigt wird. Alternativ können in einem Schritt (vi) auch andere Reinigungsverfahren wie Umkristallisation eingesetzt werden, um das im Schritt (v) erhaltene (MoO₂Cl₂) noch weiter aufzureinigen. Auf diese Weise kann ein (MoO₂Cl₂) mit noch weiter verbesserter Reinheit bereitgestellt werden. Ein solches (MoO₂Cl₂) kann in einem nachfolgenden Verfahren, insbesondere in einem Verfahren der Gasphasenabscheidung, zu einer besonders reinen Molybdän-haltigen Schicht mit verbesserten elektronischen Eigenschaften umgesetzt werden. Erfindungsgemäß ist es dementsprechend bevorzugt, dass das erfindungsgemäße Verfahren keinen Schritt aufweist, in welchem hergestelltes festes (MoO₂Cl₂) nasschemisch verarbeitet wird, insbesondere keinen Schritt einer Umsetzung von hergestelltem festen (MoO₂Cl₂) mit Ammoniakwasser. Durch eine derartige Umsetzung entstände typischerweise Chlorwasserstoff (HCl). Eine Entstehung von HCl soll erfindungsgemäß aber vermieden werden, damit kein diesbezügliches Entsorgungsproblem oder die Gefahr einer unerwünschten Korrosion der eingesetzten Apparatur einschließlich Reaktionsgefäß und Auffanggefäß durch das HCl entsteht.

Gegenstand der Erfindung ist auch ein Verfahren zur Herstellung einer Molybdän-haltigen Schicht, welches ein erfindungsgemäßes Verfahren umfasst, wobei im Anschluss daran, d.h. nach dem Schritt (v), oder falls durchgeführt nach dem Schritt (vi), das im Schritt (v) oder Schritt (vi) erhaltene (MoO₂Cl₂) in einer Gasphasenabscheidung als Präkursor eingesetzt wird, um die Molybdän-haltige Schicht auszubilden. Erfindungsgemäß ist es bevorzugt, dass für die Gasphasenabscheidung eine chemische Gasphasenabscheidung (CVD) oder eine Atomlagenabscheidung (ALD) eingesetzt wird.

Die chemische Gasphasenabscheidung bzw. CVD ist eine Gasphasenreaktion, die in der Regel an oder in der Nähe einer Oberfläche eines Substrats abläuft. Dabei werden an der Reaktion beteiligte Reaktanten in Form von Gasen gleichzeitig dem zu beschichtenden Substrat zugeleitet. Das Substrat ist dabei in einer Reaktionskammer angeordnet und wird beheizt. Die meist vorgeheizten Gase werden durch das beheizte Substrat thermisch aktiviert und reagieren miteinander. Dabei wird das erwünschte Material abgeschieden und chemisch gebunden. Es kommt zu einer Chemisorption des erwünschten Materials, in der vorliegenden Erfindung des Molybdäns.

Das ALD-Verfahren, auch als Atomlagenabscheidung bezeichnet, ist ein verändertes CVD-Verfahren. Beim ALD-Verfahren endet die Reaktion bzw. Sorption an der Oberfläche nach der vollständigen Belegung der Oberfläche von sich aus. Diese selbstbegrenzende Reaktion wird in mehreren Zyklen durchlaufen, die von dazwischenliegenden Spülschritten begrenzt werden. Auf diese Weise können sehr exakte Schichtdicken erreicht werden.

Gegenstand der Erfindung ist auch (MoO₂Cl₂), welches durch ein erfindungsgemäßes Verfahren erhältlich ist. Ein solches (MoO₂Cl₂) ist ein hochreines (MoO₂Cl₂) und eignet sich insbesondere als Präkursor zur Herstellung von hochreinen Molybdän-haltigen Schichten mit verbesserten elektronischen Eigenschaften, insbesondere verbesserten Speichereigenschaften, z.B. beim Einsatz in Flash-Speichern wie einem 3D-NAND. Ein solches (MoO₂Cl₂) ist bevorzugt ein (MoO₂Cl₂) mit niedrigem Wassergehalt, besonders bevorzugt ein wasserfreies bzw. trockenes MoO₂Cl₂.

Gegenstand der Erfindung ist auch (MoO₂Cl₂), welches eine Reinheit bestimmt durch ICP-OES/MS von 0.9996 Gew.-% oder mehr und mehr bevorzugt von 0.99969 Gew.-% oder mehr aufweist. Es ist dabei besonders bevorzugt, dass das (MoO₂Cl₂) einen Wolframgehalt bestimmt durch ICP-OES/MS von ≤ 200 ppb, mehr bevorzugt von ≤ 100 ppb und noch mehr bevorzugt von ≤ 50 ppb aufweist. Ein solches (MoO₂Cl₂) ist ebenfalls ein hochreines (MoO₂Cl₂) und eignet sich insbesondere als Präkursor zur Herstellung von hochreinen Molybdän-haltigen Schichten mit verbesserten elektronischen Eigenschaften, insbesondere verbesserten Speichereigenschaften, z.B. beim Einsatz in Flash-Speichern wie einem 3D-NAND. Ein solches (MoO₂Cl₂) ist bevorzugt ein (MoO₂Cl₂) mit niedrigem Wassergehalt, besonders bevorzugt ein wasserfreies bzw. trockenes MoO₂Cl₂.

Gegenstand der Erfindung ist auch eine Verwendung des erfindungsgemäß erhältlichen bzw. bereitgestellten MoO₂Cl₂ als Präkursor zur Herstellung einer Molybdän-haltigen Schicht. Insbesondere kann das (MoO₂Cl₂) zur Herstellung einer Molybdän-haltigen Schicht mittels Gasphasen-Dünnschichtverfahren wie der vorstehend beschriebenen CVD oder ALD dienen.

Gegenstand der Erfindung ist zudem eine Elektronikkomponente, die eine erfindungsgemäß hergestellte Molybdän-haltige Schicht umfasst. Aufgrund der verbesserten Reinheit des erfindungsgemäß bereitgestellten (MoO₂Cl₂) ist die Molybdän-haltige Schicht ebenfalls besonders rein und ist insbesondere nahezu bis vollständig frei von Wolframverunreinigungen. Dadurch kann die Elektronikkomponente mit verbesserten elektronischen Eigenschaften ausgestattet sein.

Erfindungsgemäß ist es bevorzugt, dass die Elektronikkomponente ein sogenanntes 3D-NAND ist. Ein 3D-NAND ist ein nichtflüchtiger Speicher ("*Flash-Speicher*"), bei dem mehrere Speicherzellen vertikal in mehreren Schichten gestapelt sind. Die Speicherzellen sind dabei seriell verschaltet. Zum Beispiel können 16, 32, 64, 96 oder 128 Speicherzellen verschaltet sein, um eine erhöhte Speicherdichte zu erzielen. Durch Einsatz einer erfindungsgemäß hergestellten Molybdän-haltigen Schicht in einem solchen nichtflüchtigen Speicher können dessen elektronische Eigenschaften verbessert sein, insbesondere können dessen Speichereigenschaften verbessert sein.

### Ausführungsbeispiel

Als Reaktionsgefäß wird ein Drehrohrofen mit einer Rohrlänge von 1 m und einem Rohrdurchmesser von 5 cm eingesetzt. Der Drehrohrofen ist über einen Übergangsbereich mit einem Produktkolben als Auffanggefäß verbunden. Drehrohrofen, Übergangsbereich und Produktkolben sind getrennt beheizbar. In dem Drehrohrofen werden 400 g MoO₂ vorgelegt. Anschließend wird in der gesamten Apparatur durch Einleiten von Stickstoff (0,4 L/min N₂) eine Inertgasatmosphäre geschaffen. Danach werden der Drehrohrofen auf eine Temperatur (T₁) von 400°C, der Übergangsbereich auf eine Temperatur von 160°C und der Produktkolben auf eine Temperatur (T₂) von 70°C gebracht. Nach Erreichen dieser Temperaturen wird ein N₂-Strom von 0,2 L/min eingestellt. Danach wird zusätzlich Cl₂ in den Drehrohrofen eingeleitet (0,8 L/min Cl₂). Man lässt das vorgelegte MoO₂ mit dem eingeleiteten Cl₂ zwei Stunden (2 h) lang reagieren. Danach wird das Einleiten von Cl₂ sowie das Beheizen von Drehrohrofen und Übergangsbereich beendet, und man lässt den Produktkolben auf 25°C abkühlen. Der N₂-Strom wird auf 1 L/min erhöht und für 30 min fortgesetzt. Danach wird das Einleiten von N₂ beendet, und der Produktkolben wird im Ar-Gegenstrom von der Apparatur abgenommen. Der Produktkolben wird in eine Handschuhbox mit Inertgasatmosphäre eingeschleust und dort abgepackt.

Aus dem Produktkolben wird ferner eine Probe zur Bestimmung des Gehalts an Verunreinigungen entnommen. Die Bestimmung erfolgt wiederum mittels ICP-OES/MS. Dafür werden Geräte der Firma Thermo Fischer mit den Typenbezeichnungen iCap, iCap Duo bzw. iCap RQ eingesetzt. Es wurden die in der folgenden Tabelle 1 angegebenen Verunreinigungen bestimmt (die angegebenen ppb-Werte entsprechenden der jeweiligen Nachweisgrenze):

**Tabelle 1**

| **Element** | **Gehalt in ppb** | | **Element** | **Gehalt in ppb** |
|---|---|---|---|---|
| Ag | < 50 | | Mn | < 20 |
| AI | < 50 | | Na | < 150 |
| Au | < 50 | | Nb | < 100 |
| B | < 50 | | Ni | < 50 |
| Ba | < 50 | | Pb | < 20 |
| Be | < 20 | | Pd | < 50 |
| Bi | < 20 | | Pt | < 50 |
| Ca | 100 | | Rb | < 50 |
| Cd | < 150 | | Rh | < 50 |
| Ce | < 50 | | Ru | < 50 |
| Co | < 50 | | Sb | < 20 |
| Cr | < 50 | | Se | < 50 |
| Cu | < 50 | | Sn | < 100 |
| Fe | < 50 | | Sr | < 50 |
| Ga | < 50 | | Te | < 100 |
| Ge | < 20 | | Th | < 20 |
| Hf | < 20 | | Ti | < 200 |
| In | < 50 | | Tl | 300 |
| Ir | < 50 | | U | < 20 |
| K | < 200 | | V | < 50 |
| La | < 20 | | W | < 200 |
| Li | < 20 | | Zn | < 50 |
| Mg | < 50 | | Zr | < 50 |

Die Summe der Verunreinigungen liegt damit insgesamt bei < 3070 ppb. Das hergestellte MoO₂Cl₂ weist dementsprechend eine Reinheit von mindestes 99,9996930 Gew.-% auf.

## Patentansprüche

1. Verfahren zur Herstellung von MoO₂Cl₂ unter inerten Bedingungen, umfassend die Schritte:
(i) Vorlegen von MoO₂ in einem Reaktionsgefäß,
(ii) Umsetzen des MoO₂ in dem Reaktionsgefäß bei einer ersten Temperatur T₁ mit zugeführtem Cl₂ zu gasförmigem MoO₂Cl₂,
(iii) Überführen des gasförmigen MoO₂Cl₂ in ein Auffanggefäß,
(iv) Resublimieren des gasförmigen MoO₂Cl₂ in dem Auffanggefäß zu festem MoO₂Cl₂ bei einer zweiten Temperatur T₂, die niedriger als T₁ liegt, und
(v) Rückgewinnen von festem MoO₂Cl₂ mit einer Reinheit bestimmt durch ICP-OES/MS von 99,9996 Gew.-% oder mehr.

2. Verfahren gemäß Anspruch 1, wobei im Schritt (v) festes MoO₂Cl₂ mit einer Reinheit bestimmt durch ICP-OES/MS von 99,99969 Gew.-% oder mehr rückgewonnen wird.

3. Verfahren gemäß mindestens einem der vorhergehenden Ansprüche, wobei im Schritt (v) festes MoO₂Cl₂ mit einem Wolframgehalt bestimmt durch ICP-OES/MS von ≤ 200 ppb, bevorzugt von ≤ 50 ppb, rückgewonnen wird.

4. Verfahren gemäß mindestens einem der vorhergehenden Ansprüche, wobei die erste Temperatur T₁ ≥ 170°C, bevorzugt 170 bis 600°C beträgt, und/oder die zweite Temperatur T₂ ≤ 160°C, bevorzugt 20 bis 90°C beträgt.

5. Verfahren gemäß mindestens einem der vorhergehenden Ansprüche, wobei der Schritt (iii) bei einer Temperatur von ≥ 160°C durchgeführt wird.

6. Verfahren gemäß mindestens einem der vorhergehenden Ansprüche, wobei im Schritt (ii) der Gasstrom des Cl₂ 0,01 bis 1 L/min, bevorzugt 0,05 bis 0,8 L/min beträgt.

7. Verfahren gemäß mindestens einem der vorhergehenden Ansprüche, wobei im Schritt (ii) zusätzlich ein Inertgas, bevorzugt N₂, zugeführt wird.

8. Verfahren gemäß Anspruch 7, wobei der Gasstrom des Inertgases 0,05 bis 0,4 L/min, bevorzugt 0,1 bis 0,3 L/min beträgt.

9. Verfahren gemäß mindestens einem der vorhergehenden Ansprüche, wobei das Reaktionsgefäß und das Auffanggefäß vor dem Schritt (i) durch Spülen mit einem Inertgas, bevorzugt N₂, inertisiert werden.

10. Verfahren gemäß mindestens einem der vorhergehenden Ansprüche, wobei das im Schritt (v) erhaltene (MoO₂Cl₂) in einem nachfolgenden Schritt (vi) durch Sublimation und erneute Resublimation weiter gereinigt wird.

11. Verfahren zur Herstellung einer Molybdän-haltigen Schicht, umfassend ein Verfahren gemäß mindestens einem der vorhergehenden Ansprüche, wobei im Anschluss daran das im Schritt (v) oder Schritt (vi) erhaltene (MoO₂Cl₂) in einer Gasphasenabscheidung als Präkursor eingesetzt wird, um die Molybdän-haltige Schicht auszubilden.

12. (MoO₂Cl₂), erhältlich durch ein Verfahren gemäß mindestens einem der Ansprüche 1 bis 10.

13. (MoO₂Cl₂), welches eine Reinheit bestimmt durch ICP-OES/MS von 0.9996 Gew.-% oder mehr und bevorzugt einen Wolframgehalt bestimmt durch ICP-OES/MS von ≤ 200 ppb aufweist.

14. Verwendung von (MoO₂Cl₂) nach Anspruch 12 oder 13 als Präkursor zur Herstellung einer Molybdän-haltigen Schicht.

15. Elektronikkomponente, insbesondere ein 3D-NAND, umfassend eine gemäß Anspruch 11 oder 14 hergestellte Molybdän-haltige Schicht.
